(19) **Europäisches Patentamt European Patent Office Office européen des brevets**

(11) **EP 2 659 526 B1**

(12) **FASCICULE DE BREVET EUROPEEN**

(45) Date de publication et mention de la délivrance du brevet:
**11.03.2015 Bulletin 2015/11**

(21) Numéro de dépôt: **11813880.9**

(22) Date de dépôt: **23.12.2011**

(51) Int Cl.:
***H01L 35/32*** *(2006.01)*

(86) Numéro de dépôt international:
**PCT/FR2011/000676**

(87) Numéro de publication internationale:
**WO 2012/089932 (05.07.2012 Gazette 2012/27)**

(54) **DISPOSITIF THERMOÉLECTRIQUE MODULABLE ET AJUSTABLE ET PROCÉDÉ DE FONCTIONNEMENT DU DISPOSITIF THERMOÉLECTRIQUE.**

**MODULARE VERSTELLBARE THERMOELEKTRISCHE VORRICHTUNG UND VERFAHREN FÜR DEN BETRIEB DER THERMOELEKTRISCHEN VORRICHTUNG**

**MODULAR ADJUSTABLE THERMOELECTRIC DEVICE, AND METHOD FOR OPERATING SAID THERMOELECTRIC DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2010 FR 1005146**

(43) Date de publication de la demande:
**06.11.2013 Bulletin 2013/45**

(73) Titulaires:
• **Commissariat à l'Énergie Atomique et aux Énergies Alternatives 75015 Paris (FR)**
• **ST-Ericsson SA 1228 Plan-les-Ouates (CH)**

(72) Inventeurs:
• **NAVONE, Christelle F-38430 Saint Jean de Moirans (FR)**
• **CAROFF, Tristan F-38610 Gières (FR)**
• **COTTIN, Denis F-38920 Crolles (FR)**

(74) Mandataire: **Talbot, Alexandre et al Cabinet Hecké Europole, BP 1537 10, rue d'Arménie 38025 Grenoble Cedex 1 (FR)**

(56) Documents cités:
**US-A- 5 705 770**

EP 2 659 526 B1

## Description

### Domaine technique de l'invention

L'invention est relative à un dispositif thermoélectrique comportant un premier ensemble de systèmes thermoélectriques unitaires identiques, chaque système thermoélectrique unitaire comportant au moins un thermocouple.

### État de la technique

Dans le domaine des énergies renouvelables, un dispositif thermoélectrique permet l'exploitation d'un écart de température entre deux faces du dispositif pour générer un courant électrique, on parle alors de dispositif générateur de courant, ou de dispositif à effet Seebeck. Ces dispositifs thermoélectriques permettent aussi la génération d'un écart de température en présence d'un courant électrique imposé dans le dispositif thermoélectrique, alors appelé dispositif à effet Peltier.

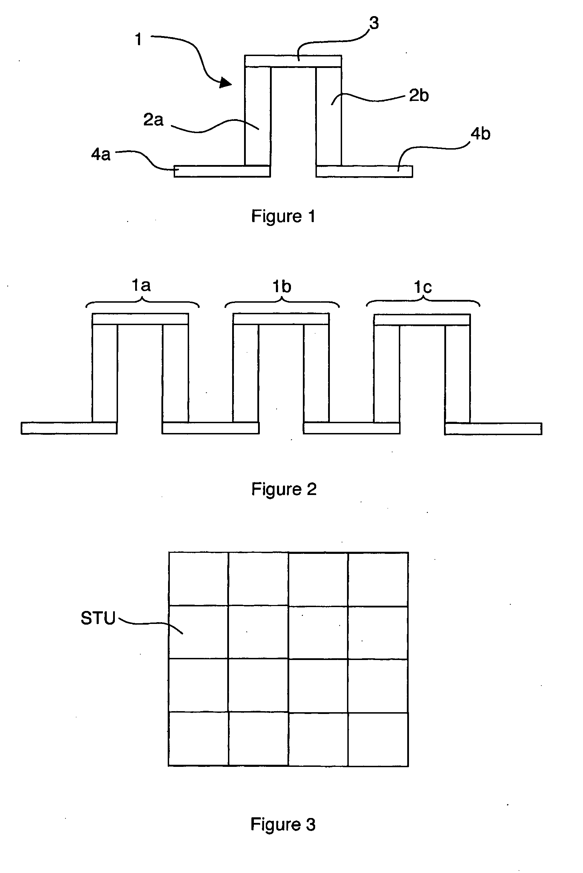

Un dispositif thermoélectrique comporte en général une pluralité de thermocouples. En fait, comme illustré à la figure 1, un thermocouple 1, aussi appelé jonction thermoélectrique, est un élément unitaire comportant deux plots (ou thérmoéléments) 2a, 2b en matériaux thermoélectriques, en parallèle thermiquement entre eux, et reliés entre eux à l'une de leurs extrémités coplanaires, par exemple, par un élément de liaison 3, formant une jonction chaude ou froide. L'autre extrémité des deux plots est reliée, de préférence, respectivement à deux éléments de connexion 4a, 4b permettant de relier électriquement le thermocouple à, par exemple, deux autres thermocouples comme illustré à la figure 2 pour former une série de trois thermocouples 1a, 1b, 1c reliés électriquement en série et thermiquement en parallèle. Les deux éléments de connexion 4a, 4b (figure 1) forment en opposition à l'élément de liaison 3 une jonction complémentaire, c'est-à-dire froide ou chaude. Les deux plots 2a, 2b peuvent être formés dans des matériaux différents, ou des matériaux dopés électriquement, préférentiellement l'un des plots étant dopé P et l'autre plot étant dopé N.

Dans l'optique de favoriser le développement des énergies renouvelables, les thermocouples peuvent être connectés électriquement en grand nombre de sorte à exploiter les déperditions thermiques de radiateurs, d'usines, etc., et générer ainsi un courant.

À ce jour il n'existe pas de dispositifs thermoélectriques capables de s'adapter aux aléas de fonctionnement. Par aléas de fonctionnement, on entend par exemple des variations brusques de température, la détérioration d'un ou plusieurs thermocouples, etc.

Le document US5,705,770 décrit un dispositif muni de deux éléments thermoélectriques aptes à être branchés soit en série soit en parallèle. Ces éléments font toujours partie intégrante du circuit

### Objet de l'invention

L'objet de l'invention vise un dispositif ne présentant pas les inconvénients de l'art antérieur.

On tend vers cet objet par les revendications annexées et notamment en ce que le premier ensemble comporte des systèmes thermoélectriques unitaires fonctionnels et au moins un système thermoélectrique unitaire défaillant et en ce que le dispositif comprend :

- des moyens de détection de systèmes thermoélectriques unitaires fonctionnels du premier ensemble de systèmes thermoélectriques unitaires,
- des moyens aptes à connecter électriquement un second ensemble de systèmes thermoélectriques unitaires fonctionnels choisis dans ledit premier ensemble de systèmes thermoélectriques unitaires, sous la forme d'un circuit électrique, de sorte que tous les systèmes thermoélectriques unitaires du circuit électrique soient traversés par un même courant.

L'invention est aussi relative à un procédé de fonctionnement d'un dispositif thermoélectrique comprenant un premier ensemble de systèmes thermoélectriques unitaires, le premier ensemble comporte au moins un système thermoélectrique unitaire défaillant et des systèmes thermoélectriques unitaires fonctionnels, et le procédé comporte les étapes suivantes :

- détecter les systèmes thermoélectriques unitaires fonctionnels dans le premier ensemble de systèmes thermoélectriques unitaires,
- connecter électriquement un second ensemble de systèmes thermoélectriques unitaires fonctionnels, choisis dans le premier ensemble de systèmes thermoélectriques unitaires, pour former un circuit électrique de sorte que tous les systèmes thermoélectriques unitaires dudit circuit électrique soient traversés par un courant identique.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre un thermocouple.

La figure 2 illustre trois thermocouples connectés en série.

La figure 3 illustre une matrice de seize systèmes thermoélectriques unitaires identiques.

La figure 4 illustre schématiquement un mode de réalisation d'un dispositif thermoélectrique.

La figure 5 illustre des moyens de détection d'une défaillance, ou de fonctionnement, d'un système thermoélectrique unitaire.

La figure 6 illustre la matrice de la figure 3 dans laquelle les systèmes thermoélectriques unitaires identiques sont tous connectés en série.

La figure 7 illustre la matrice de la figure 3 dans laquelle les systèmes thermoélectriques unitaires identiques sont divisés en deux séries électriques de huit systèmes thermoélectriques unitaires, les séries étant connectées électriquement en parallèle.

## Description de modes préférentiels de réalisation

Le dispositif décrit ci-après diffère de ceux de l'art antérieur en ce qu'il est capable de s'adapter, par exemple lors d'une défaillance d'un système thermoélectrique unitaire, ou en vue d'ajuster la connectique du circuit afin de bénéficier d'un circuit optimal (par exemple optimisant la résistance interne et la force électromotrice) en fonction des variations d'un flux thermique au niveau du dispositif. Pour cela, il comporte des moyens aptes à connecter un sous-ensemble de systèmes thermoélectriques unitaires fonctionnels d'un premier ensemble de systèmes thermoélectriques unitaires identiques. Ceci présente l'avantage de ne pas nécessiter d'intervention humaine pour réparer un dispositif dont l'un des systèmes thermoélectriques unitaires viendrait à tomber en panne, le dispositif est alors autonome. En effet, en fonction de l'utilisation du dispositif, ce dernier n'est pas forcément accessible par une personne pour lui donner l'occasion d'identifier la panne, puis de remplacer aisément le ou les systèmes thermoélectriques unitaires défaillants.

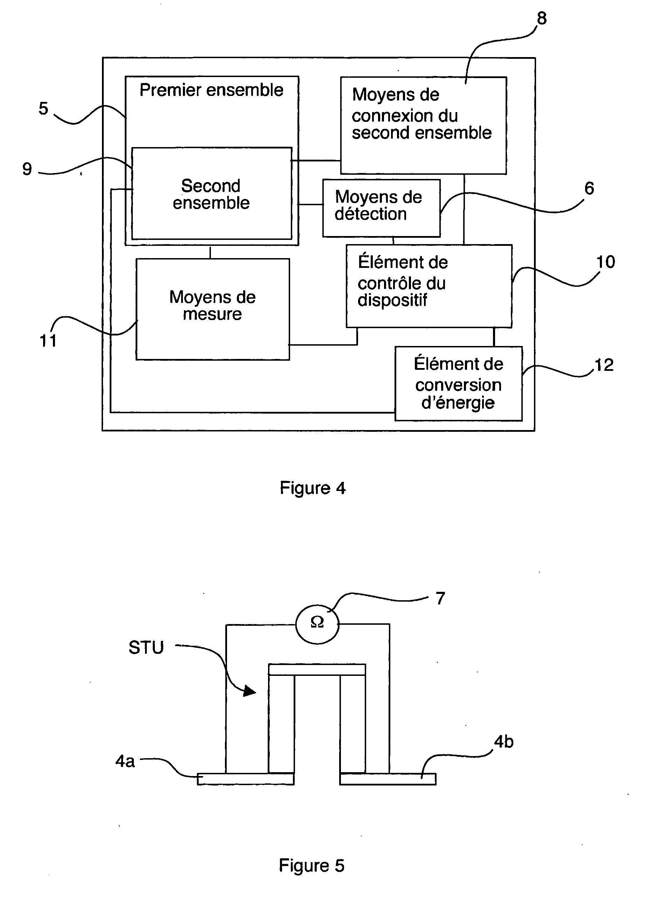

Le dispositif thermoélectrique illustré aux figures 3 et 4 comporte un premier ensemble 5 de systèmes thermoélectriques unitaires identiques, par exemple agencés sous la forme d'une matrice (figure 3). Chaque système thermoélectrique unitaire du premier ensemble comporte au moins un thermocouple.

Par identique, on entend qu'un système thermoélectrique unitaire du premier ensemble comporte les mêmes caractéristiques et schémas électriques que les autres systèmes thermoélectriques unitaires du premier ensemble. En fait, un système thermoélectrique unitaire peut comporter un unique thermocouple (figure 1) ou une pluralité de thermocouples (figure 2) associés en série ou en série/parallèle. De préférence, tous les thermocouples d'un système thermoélectrique unitaire sont traversés par un courant identique pour limiter l'effet parasite au sein du système thermoélectrique unitaire. L'effet physique parasite correspond à la génération d'un effet opposé à celui qui lui a donné naissance lorsqu'un thermocouple fonctionne dans un mode, ainsi en mode Peltier le thermocouple peut générer un effet parasite Seebeck et inversement.

Ce premier ensemble 5 peut en fait comporter la totalité des systèmes thermoélectriques unitaires que l'on peut trouver dans le dispositif, c'est-à-dire seize systèmes thermoélectriques unitaires dans l'exemple particulier de la figure 3 (où un carré représente un système thermoélectrique unitaire STU). Ce nombre de systèmes thermoélectriques unitaires du premier ensemble 5 est, de préférence, supérieur au nombre de systèmes thermoélectriques unitaires nécessaires défini dans le cahier des charges du client afin d'assurer un fonctionnement optimal tout au long de la vie du dispositif. Chaque système thermoélectrique unitaire peut avoir la forme du thermocouple de la figure 1 décrite dans l'art antérieur si le système thermoélectrique unitaire concerné comporte un unique thermocouple.

Le dispositif comporte en outre des moyens de détection 6 de systèmes thermoélectriques unitaires fonctionnels du premier ensemble 5 de systèmes thermoélectriques unitaires. Ces moyens de détection permettent en fait de détecter les systèmes thermoélectriques unitaires fonctionnels, et donc les défaillants, du premier ensemble 5. Un système thermoélectrique unitaire fonctionnel est un système thermoélectrique ayant une continuité électrique, c'est-à-dire, par exemple, qu'un courant peut circuler dans le système thermoélectrique unitaire entre deux bornes dudit système. Par bornes d'un système thermoélectrique unitaire, on entend des bornes électriques dudit système permettant par exemple de relier les systèmes électriquement entre eux. Chaque système comporte alors deux bornes.

Ainsi, les moyens de détection 6 des systèmes thermoélectriques unitaires fonctionnels peuvent comporter, comme illustré à la figure 5, un élément de mesure 7 de la continuité électrique dans un système thermoélectrique unitaire du premier ensemble 5 de systèmes thermoélectriques unitaires. Cet élément de mesure 7 peut, par exemple, être un ohmmètre connecté électriquement aux deux bornes du système thermoélectrique unitaire STU associé (sur l'exemple particulier de la figure 5, les deux bornes du système coïncident avec les éléments de liaison 4a, 4b d'un thermocouple). De préférence, chaque système thermoélectrique unitaire du premier ensemble 5 est associé à un élément de mesure distinct, permettant ainsi de cartographier à tout instant les systèmes thermoélectriques unitaires défaillants et fonctionnels du premier ensemble 5.

Le dispositif comporte aussi des moyens 8 aptes à connecter électriquement un second ensemble 9 de systèmes thermoélectriques unitaires fonctionnels choisis dans le premier ensemble 5, sous la forme d'un circuit électrique, de sorte que tous les systèmes thermoélectriques unitaires du circuit soient traversés par un même courant (définissant une condition sur le courant), pour entre autre éviter l'effet parasite décrit ci-dessus. Comme illustré à la figure 4, les moyens 8 aptes à connecter électriquement le second ensemble 9 de systèmes thermoélectriques unitaires peuvent être pilotés par un élément de contrôle 10 connecté aux moyens de détection 6 (eux mêmes reliés au premier ensemble 5) pour être informé de la liste des systèmes thermoélectriques unitaires fonctionnels et défaillants. Ainsi, l'élément de contrôle 10 peut connaître la cartographie des systèmes thermoélectriques unitaires fonctionnels du premier ensemble 5, et peut alors déterminer le second ensemble 9. L'élément de contrôle 10 peut alors être connecté aux moyens 8 aptes à connecter le second ensemble 9 pour les piloter et demander la connexion des systèmes thermoélectriques unitaires du second ensemble 9 selon un schéma électrique particulier. Le circuit peut être formé en utilisant une matrice de commutateurs (non représentée) associée aux systèmes thermoélectriques unitaires du premier ensemble 5, et agencée de sorte à permettre toutes les connexions possibles entre systèmes thermoélectriques unitaires du second ensemble 9. Afin de faciliter les connexions, chaque système thermoélectrique unitaire du premier ensemble peut comporter un commutateur électrique branché en parallèle à ses bornes, le commutateur comportant une résistance série inférieure à celle du système thermoélectrique unitaire associé, permettant de réaliser ainsi un shunt du système thermoélectrique unitaire provoquant la désactivation du système thermoélectrique unitaire concerné.

Le second ensemble 9 de systèmes thermoélectriques unitaires peut, dans un cas idéal, comporter le même nombre de systèmes thermoélectriques unitaires que le premier ensemble 5. Ce cas idéal étant celui où aucun système thermoélectrique unitaire défaillant n'est détecté, et où l'on cherche à utiliser tous les systèmes thermoélectriques unitaires du dispositif. Bien entendu, le second ensemble 9 peut aussi comporter moins de systèmes thermoélectriques unitaires que le premier ensemble 5.

Comme évoqué précédemment, les différents schémas électriques du circuit peuvent être affectés par la présence d'un effet Peltier parasite lorsque le dispositif fonctionne en mode générateur de courant (mode de fonctionnement à effet Seebeck). Cet effet consomme une partie du courant généré, et modifie localement l'écart de température au niveau des systèmes thermoelectriques unitaires du second ensemble 9, entraînant une diminution des performances du circuit. Ceci est évité si tous les systèmes thermoélectriques unitaires formant le circuit sont traversés par un courant identique.

Cette condition sur le courant peut être atteinte par exemple si tous les systèmes thermoélectriques unitaires du second ensemble sont connectés en série, en parallèle, ou si le second ensemble 9 de systèmes thermoélectriques unitaires est connecté de sorte que le circuit comporte une pluralité de séries de systèmes thermoélectriques unitaires, toutes les séries comportant un nombre identique de systèmes thermoélectriques unitaires, et étant connectées en parallèle entre elles.

La tension aux bornes du circuit formé par le second ensemble 9 de systèmes thermoélectriques unitaires est proportionnelle à l'écart de température appliqué au dispositif, c'est-à-dire au second ensemble 9 de systèmes thermoélectriques unitaires. L'écart de température peut être vu comme la différence de température entre les jonctions chaudes et les jonctions froides des thermocouples.

En effet, la force électromotrice VTEG du circuit peut être égale à $n*S_u*\Delta T$ où n est le nombre de systèmes thermoélectriques unitaires en série du circuit, $S_u$ le coefficient Seebeck d'un système thermoélectrique unitaire, fonction le cas échéant, des matériaux P et N utilisés dans chaque thermocouple, et $\Delta T$ la différence de température au niveau du générateur, c'est-à-dire la différence de température appliquée entre les jonctions chaudes et froides du, ou des, thermocouples des systèmes thermoélectriques unitaires du second ensemble 9.

Pour favoriser la tension générée par le circuit lorsque l'écart de température est faible, il est préférable que le circuit ait le plus grand nombre de systèmes thermoélectriques unitaires en série. Alors que pour un grand écart de température, il peut être préférable de diminuer la résistance du circuit, pour effectuer un transfert maximal de puissance, et pour cela il faut que le circuit ait le plus grand nombre de systèmes thermoélectriques unitaires en parallèle.

Étant donné que l'écart de température influe sur la tension, afin de pouvoir prendre en compte cet écart de température, le dispositif peut comporter des moyens de mesure 11 (figure 4) d'une différence de potentiel aux bornes d'au moins un système thermoélectrique unitaire du second ensemble 9, ou d'une portion du circuit (différence de potentiel mesurée entre deux points quelconques du circuit), ou d'un système thermoélectrique fonctionnel du premier ensemble 5. Autrement dit, le schéma électrique du circuit peut alors être fonction d'une mesure d'une différence de potentiel particulière, ladite mesure étant effectuée par les moyens de mesure 1.1 reliés à des bornes correspondantes.

Les moyens de mesure 11 peuvent être connectés, comme illustré à la figure 4, à un système thermoélectrique unitaire ou à plusieurs systèmes thermoélectriques unitaires connectés entre eux (du premier et/ou du second ensemble), et à l'élément de contrôle 10 de sorte à lui communiquer la valeur de la différence de potentiel mesurée pour déterminer le schéma électrique approprié du circuit. L'élément de contrôle 10 peut alors piloter les moyens 8 aptes à connecter le second ensemble 9 de systèmes thermoélectriques unitaires pour réaliser ledit schéma approprié. Pour cela l'élément de contrôle 10 peut comporter une table de correspondance associant une différence de potentiel à un circuit particulier.

Afin de déterminer le schéma électrique du circuit, il est possible au démarrage du dispositif de former un premier circuit quelconque (où tous les systèmes thermoélectriques unitaires sont traversés par un courant identique), d'effectuer une mesure de différence de potentiel au moins au niveau d'un système thermoélectrique unitaire du second ensemble 9, puis en fonction de la mesure, reformer un second circuit optimisé. Il est aussi possible lors du démarrage de déterminer les systèmes thermoélectriques unitaires fonctionnels du premier ensemble 5, de mesurer une différence de potentiel aux bornes de l'un des systèmes thermoélectriques unitaires fonctionnels du premier ensemble 5, puis de former le second ensemble 9 et le circuit associé à partir de ladite mesure.

La différence de potentiel pouvant évoluer au cours du temps, lorsque le dispositif est en fonctionnement, une différence de potentiel pourra être mesurée au moins aux bornes d'un système thermoélectrique unitaire du second ensemble 9 formant circuit de sorte à faire évoluer, le cas échéant, le circuit en conséquence. Pour cela, des mesures peuvent être réalisées à intervalles réguliers.

Dans un exemple particulier de réalisation, le dispositif comporte un élément de conversion d'énergie 12 connecté électriquement au circuit pour récupérer le courant et l'exploiter. L'élément de conversion d'énergie 12 peut être un convertisseur de type DC-DC, de type pompe à charge, etc. Les différents schémas électriques préférentiels du circuit sont déterminés dans la table suivante élaborée dans le cas d'un second ensemble de $2^4$ systèmes thermoélectriques unitaires pour un circuit de conversion 12 présentant la même résistance $R_{TEG}$:

Table I

| Numéro de configuration | Nombre de séries de TEGu en parallèle | Nombre de TEGu dans une série | Tension d'entrée de l'élément de conversion | Courant d'entrée de l'élément de conversion d'énergie | Puissance d'entrée de l'élément de conversion d'énergie |
|---|---|---|---|---|---|
| 1 | 1 | 16 | 8*VTEGu | VTEGu/(2*RTEGu) | $4VTEGu^2/RTEGu$ |
| 2 | 2 | 8 | 4*VTEGu | VTEGu/(1*RTEGu) | |
| 3 | 4 | 4 | 2*VTEGu | 2*VTEGu/RTEGu | |
| 4 | 8 | 2 | 1*VTEGu | 4*VTEGu/RTEGu | |
| 5 | 16 | 1 | VTEGu/2 | 8*VTEGu/RTEGu | |

En fait, la table I prend en considération que le second ensemble 9 comporte $2^4$ systèmes thermoélectriques unitaires, et que le dispositif est parfait, c'est-à-dire que tous les systèmes thermoélectriques unitaires du premier ensemble 5 seront utilisés pour former le second ensemble 9. Autrement dit, aucun des systèmes thermoélectriques unitaires n'est, et ne sera, défaillant. $VTEG_u$ correspond à la force électromotrice, c'est-à-dire la tension, générée aux bornes d'un système thermoélectrique unitaire fonctionnant en mode générateur. $RTEG_u$ correspond à la résistance d'un système thermoélectrique unitaire. Cette table énumère des configurations préférentielles pour un circuit de seize systèmes thermoélectriques unitaires satisfaisant la condition selon laquelle chaque système thermoélectrique unitaire du circuit est traversé par un courant identique.

Dans le cas particulier de la table I, les schémas possibles du circuit consistent en fait à la mise en série de tous les systèmes thermoélectriques unitaires du second ensemble, ou la mise en parallèle de tous les systèmes thermoélectriques unitaires, ou encore à la mise en parallèle de plusieurs séries de systèmes thermoélectriques unitaires du second ensemble 9, lesdites séries mises en parallèle ayant toutes le même nombre de systèmes thermoélectriques unitaires.

Dans un premier temps, on remarque que pour un transfert optimal de puissance, l'élément de conversion d'énergie 12 doit présenter une résistance d'entrée équivalente à la résistance interne du circuit formé par le second ensemble 9. Autrement dit, la tension d'entrée de l'élément de conversion d'énergie 12 est égale à la tension VTEG totale du circuit divisée par deux. Ceci nécessite notamment d'adapter l'impédance de l'élément de conversion d'énergie 12 au circuit formé par le second ensemble 5 de systèmes thermoélectriques unitaires. Ainsi, l'élément de conversion d'énergie peut comporter des moyens d'adaptation de son impédance en fonction de la résistance du circuit associé.

Ainsi, la lecture de la table I permet de constater, dans le cas où les systèmes thermoélectriques unitaires sont tous connectés en série, que l'on favorise la tension, et dans le cas où les systèmes thermoélectriques unitaires sont tous branchés en parallèle que l'on favorise le courant. Dans les deux cas, une puissance transférable constante est conservée.

La puissance d'entrée transférée à l'élément de conversion d'énergie 12, quand la résistance interne de l'élément de conversion 12 est égale à la résistance du circuit auquel il est connecté, peut se généraliser sous la forme d'une puissance maximale $P_{in} = \left(\dfrac{2^N}{4}\right) * \dfrac{VTEG_u{}^2}{RTEG_u}$, tous les schémas de circuits de la table I présentent une puissance transférée équivalente pour des tensions d'entrée différentes pouvant se généraliser, pour $2^N$ systèmes thermoélectriques unitaires, à une valeur de tension d'entrée comprise entre $\left(\dfrac{2^N}{2}\right) * VTEG_u$ et $\dfrac{1}{2} * VTEG_u$.

Comme indiqué précédemment, le courant circulant dans tous les systèmes thermoélectriques unitaires du circuit est indépendant de l'association choisie dans la table I et vaut $\dfrac{VTEG_u}{2 * RTEG_u}$. Ceci a pour conséquence d'éviter l'effet Peltier parasite, et d'assurer l'uniformité de la température dans l'ensemble des systèmes thermoélectriques unitaires du second ensemble en vue de maximiser la puissance de sortie.

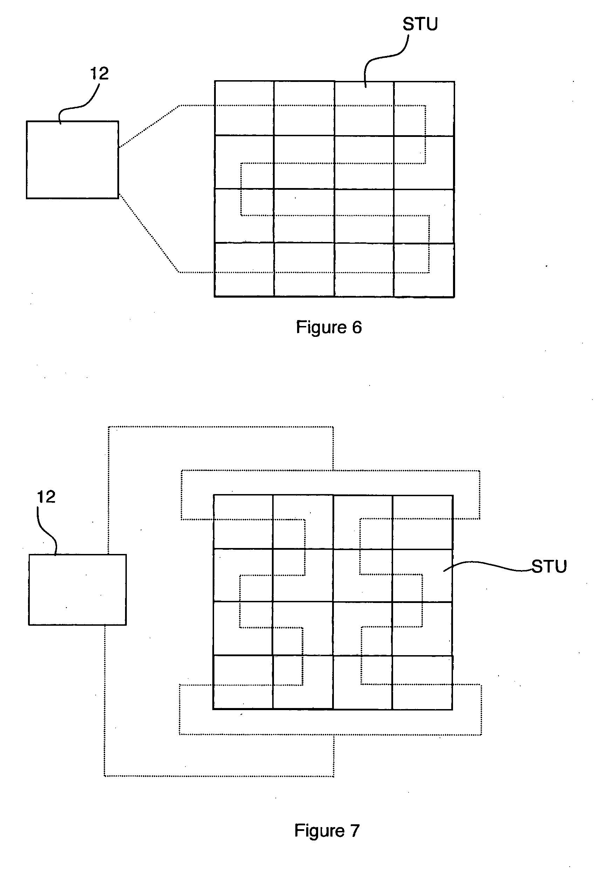

Ainsi, dans l'exemple particulier de la table 1, pour un faible écart de température donnant une faible valeur de VTEG$_u$, la configuration une de la table I sera mis en oeuvre, comme illustré à la figure 6 où les seize systèmes thermoélectriques unitaires STU sont branchés en série pour pouvoir bénéficier d'une tension optimum en entrée de l'élément de conversion d'énergie 12. Sur la figure 6, le branchement en série des systèmes thermoélectriques unitaires est illustré schématiquement par le trait en pointillé. Pour un fort écart de température, la valeur VTEG$_u$ sera élevée, et la configuration cinq de la table I sera mise en oeuvre pour transférer le maximum de courant à l'élément de conversion d'énergie. Pour des écarts intermédiaires, les configurations 2, 3 et 4 pourront être choisies. La figure 7 illustre le dispositif à seize systèmes thermoélectriques unitaires STU selon la configuration numéro deux comportant deux séries de huit systèmes thermoélectriques unitaires, lesdites séries étant connectées électriquement en parallèle au niveau de deux collecteurs de courant correspondants, eux même reliés à l'élément de conversion d'énergie 12.

Le schéma choisi pourra aussi être fonction du ratio d'élévation de l'élément de conversion d'énergie 12 (rapport de la tension de sortie sur la tension d'entrée) à produire par l'élément de conversion d'énergie 12 en fonction de l'évolution de l'écart de température. Autrement dit, au cours du fonctionnement du dispositif, le schéma électrique du circuit pourra changer pour s'adapter à un nouvel écart de température.

Comme évoqué ci-dessus, afin d'assurer la qualité de service dans le temps, le premier ensemble 5 de systèmes thermoélectriques unitaires peut comporter un nombre de systèmes thermoélectriques unitaires supérieur au nombre minimum requis pour atteindre la puissance requise de l'élément de conversion d'énergie 12. En notant le nombre minimum de systèmes thermoélectriques unitaires $2^N$, on considère que le premier ensemble comporte $2^N$ plus $2^R$ systèmes thermoélectriques unitaires. Ainsi, au cours de la vie du dispositif, si certains systèmes thermoélectriques unitaires du premier ensemble tombent en panne, il sera toujours possible de reconnecter $2^N$ systèmes thermoélectriques unitaires pour garantir la capacité du circuit, c'est-à-dire générer la puissance requise au niveau de l'élément de conversion 12. Un système thermoélectrique unitaire peut avoir une durée de vie plus ou moins limitée en fonction des défauts de fabrication, de sa durée de vie en fonctionnement, etc. De plus, un nombre élevé de systèmes thermoélectriques unitaires permet aussi de pallier aux éventuels problèmes de fabrication du dispositif dans lequel certains systèmes thermoélectriques unitaires seraient défaillants dès la fin de fabrication du dispositif. Au cours de la vie du dispositif, le nombre de systèmes thermoélectriques unitaires disponibles et fonctionnels du premier ensemble 5 varie de la façon suivante $2^N + x * \sum 2^p$ avec p variant de 0 à R et x valant 1, si p est compris entre 1 et R, ou 0 si p égal 0.

Dès lors, si le dispositif comporte un élément de conversion d'énergie 12 connecté électriquement au circuit, le nombre de systèmes thermoélectriques unitaires du second ensemble 9 peut être fonction d'une puissance d'entrée requise de l'élément de conversion d'énergie 12. Ainsi, le fait de disposer de systèmes thermoélectriques unitaires en plus peut aussi permettre de faire varier la puissance que l'on souhaite fournir à l'entrée de l'élément de conversion 12.

La table ci-dessous énumère des schémas électriques de circuits possibles pour 16, 18, 20, 24 systèmes thermoélectriques unitaires dans le second ensemble 9 (le premier ensemble 5 comprenant 24 systèmes thermoélectriques unitaires), en association série parallèles, c'est-à-dire comportant une ou plusieurs séries chaque série étant, le cas échéant, connectées électriquement en parallèle avec les autres séries, et les séries comportant toutes le même nombre de systèmes thermoélectriques unitaires.

Table 2

| numéro | $2^4$ | | $2^4+2^3$ | | $2^4+2^2+2^1$ | | $2^4+2^2$ | | $2^4+2^1$ | |
|---|---|---|---|---|---|---|---|---|---|---|
| | P | S | P | S | P | S | P | S | P | S |
| 1 | 1 | 16 | 3 | 8 | 11 | 2 | 5 | 4 | 9 | 2 |
| 2 | 2 | 8 | 6 | 4 | 22 | 1 | 10 | 2 | 18 | 1 |
| 3 | 4 | 4 | 12 | 2 | -- | -- | 20 | 1 | -- | -- |
| 4 | 8 | 2 | 24 | 1 | -- | -- | -- | -- | -- | -- |
| 5 | 16 | 1 | -- | -- | -- | -- | -- | -- | -- | -- |

La table 2 ci-dessus définit une première contrainte, à savoir que le dispositif doit toujours comporter au minimum $2^4$ systèmes thermoélectriques unitaires disponibles parmi les 24 du premier ensemble de systèmes thermoélectriques unitaires (N= 4 et R = 3). La colonne associée à $2^4$ représente les différentes combinaisons respectant la condition sur le courant pour 16 systèmes thermoélectriques unitaires formant le circuit.

P représente le nombre de séries en parallèle de systèmes thermoélectriques unitaires (1 représentant une série seule, 2 deux séries en parallèles, etc.), et S représente le nombre de systèmes thermoélectriques unitaires par série de systèmes thermoélectriques unitaires.

Sachant que le dispositif mis à la disposition du client, comporte en fait 24 systèmes thermoélectriques unitaires, la colonne associée à $2^4+2^3$ représente les différentes combinaisons respectant la condition sur le courant pour 24 systèmes thermoélectriques unitaires fonctionnels formant le circuit (autrement dit, dans ce cas, le premier ensemble est identique au second ensemble).

La colonne associée à $2^4+2^2+2^1$ correspond aux associations possibles du maximum de systèmes thermoélectriques unitaires fonctionnels du premier ensemble, c'est-à-dire 22, sachant qu'un ou deux systèmes thermoélectriques unitaires sont défaillants. En fait, si un système thermoélectrique unitaire est défaillant, un autre système thermoélectrique unitaire sera déconnecté de sorte à satisfaire la condition relative au courant.

La colonne $2^4+2^2$ correspond aux associations possibles du maximum de systèmes thermoélectriques unitaires fonctionnels du premier ensemble, c'est-à-dire 20, sachant que trois ou quatre systèmes thermoélectriques unitaires sont défaillants. En fait, si trois systèmes thermoélectriques unitaires sont défaillants, un quatrième système thermoélectrique unitaire sera déconnecté de sorte à satisfaire la condition relative au courant.

La colonne $2^4+2^1$ correspond aux associations possibles du maximum de systèmes thermoélectriques unitaires fonctionnels du premier ensemble, c'est-à-dire 18, sachant que cinq ou six systèmes thermoélectriques unitaires sont défaillants. En fait, si cinq systèmes thermoélectriques unitaires sont défaillants, un sixième système thermoélectrique unitaire sera déconnecté de sorte à satisfaire la condition relative au courant.

Dans le cas où 24 systèmes thermoélectriques unitaires peuvent être connectés pour former le circuit la puissance du circuit ainsi formé est de $6 * \dfrac{VTEG_u^{\,2}}{RTEG_u}$, pour 22 systèmes thermoélectriques unitaires la puissance est de $\dfrac{11}{2} * \dfrac{VTEG_u^{\,2}}{RTEG_u}$, pour 20 systèmes thermoélectriques unitaires la puissance est de $5 * \dfrac{VTEG_u^{\,2}}{RTEG_u}$, pour 18 systèmes thermoélectriques unitaires la puissance est de $\dfrac{9}{2} * \dfrac{VTEG_u^{\,2}}{RTEG_u}$, et pour 16 systèmes thermoélectriques unitaires la puissance est de $4 * \dfrac{VTEG_u^{\,2}}{RTEG_u}$. Bien entendu, si 24 systèmes thermoélectriques unitaires sont fonctionnels en fonction de la puissance désirée les schémas des circuits à 22, 20, 18 et 16 systèmes thermoélectriques unitaires peuvent être réalisés par les moyens aptes à connecter le second ensemble, autrement dit lorsqu'un nombre de systèmes thermoélectriques unitaires fonctionnels est disponible, tous les schémas de circuit utilisant un nombre inférieur de systèmes thermoélectriques unitaires, et satisfaisant à la condition sur le courant, peuvent être réalisés.

Bien entendu, l'invention ne se limite pas au nombre de systèmes thermoélectriques unitaires de la table II, mais peut être généralisée à un nombre quelconque pair de systèmes thermoélectriques unitaires permettant une connexion en parallèle d'une pluralité de séries de systèmes thermoélectriques unitaires ayant un nombre identique de systèmes thermoélectriques unitaires, ou d'une unique série de systèmes thermoélectriques unitaires.

Selon un développement, le dispositif comporte une table comprenant différents schémas électriques du circuit en fonction d'une valeur de puissance requise, et d'une valeur de différence de potentiel. Ainsi, en fonction de la puissance requise de l'élément de conversion 12 et de la mesure de différence de potentiel, le schéma électrique du circuit à réaliser peut être extrait de ladite table. Cette table peut aussi être fonction du nombre de systèmes thermoélectriques unitaires fonctionnels du premier ensemble afin de s'approcher au plus près de la puissance requise de l'élément de conversion.

Cette table peut être réalisée en usine pour lister les différents schémas de circuits, et peut par exemple être stockée dans l'élément de contrôle 10. Grâce à elle, le circuit peut s'adapter à son environnement, et à ses éventuelles défaillances.

Le dispositif présente aussi l'avantage de pouvoir se reconfigurer en cas de détection d'une défaillance pendant son fonctionnement, ou d'une modification de la puissance d'entrée requise du fait de la variation du flux thermique reçu par le second ensemble 9, évitant ainsi une intervention manuelle. Si de telles modifications sont détectées par l'élément de contrôle 10, ce dernier peut établir un nouveau schéma électrique et piloter les moyens 8 aptes à connecter électriquement le second ensemble 9 de systèmes thermoélectriques unitaires pour reconnecter un nouveau second ensemble correspondant aux nouvelles caractéristiques du dispositif.

Selon un exemple particulier de réalisation, l'élément de conversion d'énergie 12 est destiné à être connecté à un appareil comportant deux états, un premier état étant représentatif d'un mode de fonctionnement de l'appareil à pleine puissance, et un second état étant représentatif d'un état de veille de l'appareil. Ainsi, l'élément de contrôle 10 peut être connecté à l'élément de conversion d'énergie 12 pour connaître son état de fonctionnement (figure 4). En fonction de l'état de l'élément de conversion d'énergie 12, l'élément de contrôle 10 pourra piloter les moyens apte à connecter le second ensemble 9 pour connecter un nouveau schéma de circuit avec un nouveau second ensemble de systèmes thermoélectriques unitaires adapté à la puissance requise pour le mode de fonctionnement. Dans cet exemple, les moyens de connexion 8 peuvent être pré-configurés en usine afin de disposer d'un second ensemble 9 présentant uniquement ces deux états de fonctionnement afin de simplifier la connectique et la fabrication.

Afin de généraliser le procédé de fonctionnement du dispositif tel que décrit ci-dessus, ce dernier comporte au moins une étape de détection des systèmes thermoélectriques unitaires fonctionnels dans le premier ensemble 5 de systèmes thermoélectriques unitaires, et une étape de connexion électrique du second ensemble 9 de systèmes thermoélectriques unitaires fonctionnels, choisis dans le premier 5 ensemble, pour former le circuit électrique de sorte que tous les systèmes thermoélectriques unitaires dudit circuit électrique soient traversés par un courant identique. Si le circuit est connecté à un élément de conversion d'énergie 12 comportant une puissance requise d'entrée, le nombre de systèmes thermoélectriques unitaires du second ensemble 9 peut être fonction de ladite puissance requise comme évoqué précédemment.

Selon le mode de réalisation exploitant la mesure de différence de potentiel, le procédé peut comporter au préalable de l'étape de connexion électrique, une étape de détermination du schéma électrique du circuit à former en fonction de ladite mesure. La mesure peut être réalisée aux bornes d'au moins un système thermoélectrique unitaire du second ensemble 9 ou aux bornes d'un système thermoélectrique fonctionnel du premier ensemble 5.

Les différentes étapes du procédé peuvent avoir lieu lors du démarrage du dispositif, et/ou au cours de son fonctionnement pour s'adapter à l'évolution des paramètres.

L'invention ne se limite pas à un dispositif thermoélectrique fonctionnant en mode générateur de courant, mais peut aussi s'appliquer à un dispositif thermoélectrique fonctionnant en mode Peltier, ou mode refroidisseur. On parlera alors d'effet Seebeck parasite. Dans ce mode de fonctionnement, le circuit est traversé par un courant d'entrée qui crée une différence de température et donc un refroidissement du circuit. L'effet Seebeck parasite consomme une partie de la différence de température générée et modifie localement le courant entraînant une diminution des performances. De manière similaire au mode de réalisation générateur de courant, le circuit évoluera en fonction du courant d'entrée fourni et des éléments (systèmes thermoélectriques unitaires) défaillants. Les moyens de mesure 11 utilisés pour trouver la configuration optimale du second ensemble 9 permettront une mesure du courant de cet ensemble à partir d'un ou plusieurs systèmes thermoélectriques unitaires.

Autrement dit, lorsque dans le dispositif le premier ensemble comporte des systèmes thermoélectriques unitaires fonctionnels et au moins un système thermoélectrique unitaire défaillant, il est possible de déterminer un circuit optimum de fonctionnement pour avantageusement atteindre, grâce au circuit, une puissance requise prédéterminée de fonctionnement du dispositif. Si plusieurs systèmes thermoélectriques unitaires deviennent défaillants, le circuit s'adaptera en fonction.

Le fait que tous les systèmes thermoélectriques fonctionnels circuit soient traversés par un courant identique correspond implicitement à ce que le circuit est composé uniquement de systèmes thermoélectriques unitaires fonctionnels. C'est-à-dire que pour un circuit donné, les systèmes thermoélectriques défaillants sont retirés dudit circuit de sorte à, par exemple, ne pas induire d'effet parasite de fonctionnement. Dès lors, on considère que les systèmes thermoélectriques unitaires défaillants sont déconnectés.

Comme évoqué précédemment, fournir un dispositif équipé d'une pluralité de systèmes thermoélectriques unitaires dont le nombre permet de dépasser la puissance souhaitée permet avantageusement de déconnecter les systèmes défaillants et de les remplacer par des systèmes fonctionnels de sorte à toujours assurer la puissance requise. On a donc une redondance qui permet de pallier automatiquement à certaines pannes. Dès lors, tant que cela est possible, le circuit fonctionne toujours à son optimum en fournissant la puissance requise.

En outre, le dispositif peut comporter des moyens pour déconnecter (par exemple un système d'interrupteur) les éléments défaillants de sorte à les isoler totalement du circuit. Ceci permet par exemple d'isoler électriquement les bornes de connexion d'extrémité des systèmes thermoélectriques unitaires. Autrement dit, de manière générale, chaque système thermoélectrique unitaire défaillant est donc isolé électriquement du circuit.

## Revendications

1. Dispositif thermoélectrique comportant un premier ensemble (5) de systèmes thermoélectriques unitaires identiques, chaque système thermoélectrique unitaire comportant au moins un thermocouple, où le premier ensemble comporte des systèmes thermoélectriques unitaires fonctionnels et au moins un système thermoélectrique unitaire défaillant, et en ce que le dispositif comprend :

   - des moyens de détection (6) de systèmes thermoélectriques unitaires fonctionnels du premier ensemble (5) de systèmes thermoélectriques unitaires,
   - des moyens (8) aptes à connecter électriquement un second ensemble (9) de systèmes thermoélectriques unitaires fonctionnels choisis dans ledit premier ensemble (5) de systèmes thermoélectriques unitaires, sous la forme d'un circuit électrique, de sorte que tous les systèmes thermoélectriques unitaires du circuit électrique soient traversés par un même courant.

2. Dispositif selon la revendication 1, **caractérisé en ce qu'**il est apte à fournir une puissance requise prédéterminée atteinte par le circuit, tous les systèmes thermoélectriques unitaires du circuit étant uniquement des éléments fonctionnels.

3. Dispositif selon la revendication 1, **caractérisé en ce que** le schéma électrique du circuit est fonction d'une mesure d'une différence de potentiel, effectuée par des moyens de mesure (11) reliés à des bornes d'au moins un système thermoélectrique unitaire du second ensemble (9), ou à des bornes d'un système thermoélectrique unitaire fonctionnel du premier ensemble (5).

4. Dispositif thermoélectrique selon l'une des revendications 1 à 3, **caractérisé en ce qu'**il comporte un élément de conversion d'énergie (12) connecté électriquement au circuit, le nombre de systèmes thermoélectriques unitaires du second ensemble (9) étant fonction d'une puissance d'entrée requise de l'élément de conversion d'énergie (12).

5. Dispositif thermoélectrique selon les revendications 3 et 4, **caractérisé en ce qu'**il comporte une table comprenant différents schémas électriques du circuit en fonction d'une valeur de puissance requise, et d'une valeur de différence de potentiel.

6. Dispositif selon l'une quelconque des revendications précédentes, **caractérisé en ce que** les moyens de détection (6) des systèmes thermoélectriques unitaires fonctionnels comportent un élément de mesure (7) de la continuité électrique dans un système thermoélectrique unitaire du premier ensemble (5) de systèmes thermoélectriques unitaires.

7. Dispositif selon l'une quelconque des revendications précédentes, **caractérisé en ce que** chaque système thermoélectrique unitaire du premier ensemble (5) comporte un commutateur électrique branché en parallèle à ses bornes, ledit commutateur comportant une résistance série inférieure à celle du système thermoélectrique unitaire associé.

8. Dispositif selon l'une quelconque des revendications précédentes **caractérisé en ce que** le second ensemble (9) de systèmes thermoélectriques unitaires est connecté de sorte que le circuit comporte une pluralité de séries de systèmes thermoélectriques unitaires, toutes les séries comportant un nombre identique de systèmes thermoélectriques unitaires et étant connectées en parallèle entre elles.

9. Procédé de fonctionnement d'un dispositif thermoélectrique comprenant un premier ensemble de systèmes thermoélectriques unitaires, dans lequel le premier ensemble comporte au moins un système thermoélectrique unitaire défaillant et des systèmes thermoélectriques unitaires fonctionnels, et en ce que le procédé comporte les étapes suivantes :

- détecter les systèmes thermoélectriques unitaires fonctionnels dans le premier ensemble (5) de systèmes thermoélectriques unitaires,
- connecter électriquement un second ensemble (9) de systèmes thermoélectriques unitaires fonctionnels, choisis dans le premier ensemble (5) de systèmes thermoélectriques unitaires, pour former un circuit électrique de sorte que tous les systèmes thermoélectriques unitaires dudit circuit électrique soient traversés par un courant identique.

10. Procédé selon la revendication 9 **caractérisé en ce qu'**au préalable de l'étape de connexion électrique, un schéma électrique du circuit est déterminé en fonction d'une mesure d'une différence de potentiel aux bornes d'au moins un système thermoélectrique unitaire du second ensemble (9) ou aux bornes d'un système thermoélectrique fonctionnel du premier ensemble (5).

11. Procédé selon l'une des revendications 9 et 10, **caractérisé en ce que** le circuit étant destiné à être connecté à un élément de conversion d'énergie (12) comportant une puissance requise d'entrée, le nombre de systèmes thermoélectriques unitaires du second ensemble (9) est fonction de ladite puissance requise.

**Patentansprüche**

1. Thermoelektrische Vorrichtung, umfassend eine erste Anordnung (5) von identischen thermoelektrischen Einzelsystemen, wobei jedes thermoelektrische Einzelsystem wenigstens ein Thermoelement umfasst, wobei die erste Anordnung funktionelle thermoelektrische Einzelsysteme sowie wenigstens ein ausfallendes thermoelektrisches Einzelsystem umfasst und wobei die Vorrichtung umfasst:

- Mittel zur Erfassung (6) von funktionellen thermoelektrischen Einzelsystemen der ersten Anordnung (5) von thermoelektrischen Einzelsystemen,
- Mittel (8), die geeignet sind, eine zweite Anordnung (9) von funktionellen thermoelektrischen Einzelsystemen, die aus der ersten Anordnung (5) von thermoelektrischen Einzelsystemen ausgewählt sind, in Form einer elektrischen Schaltung elektrisch zu verbinden, so dass alle thermoelektrischen Einzelsysteme der elektrischen Schaltung von einem gleichen Strom durchflossen werden.

2. Vorrichtung nach Anspruch 1, **dadurch gekennzeichnet,** dass sie geeignet ist, eine durch die Schaltung erreichte vorbestimmte erforderliche Leistung zu liefern, wobei alle thermoelektrischen Einzelsysteme der Schaltung nur funktionelle Elemente sind.

3. Vorrichtung nach Anspruch 1, **dadurch gekennzeichet,** dass der Schaltplan der Schaltung von einer Messung einer Potentialdifferenz abhängig ist, die durch Messmittel (11), welche mit Anschlüssen von wenigstens einem thermoelektrischen Einzelsystem der zweiten Anordnung (9) oder mit Anschlüssen eines funktionellen thermoelektrischen Einzelsystems der ersten Anordnung (5) verbunden sind, durchgeführt wird.

4. Thermoelektrische Vorrichtung nach einem der Ansprüche 1 bis 3, **dadurch gekennzeichnet,** dass sie ein Energieumwandlungselement (12), das mit der Schaltung elektrisch verbunden ist, umfasst, wobei die Anzahl der thermoelektrischen Einzelsysteme der zweiten Anordnung (9) von einer erforderlichen Eingangsleistung des Energieumwandlungselements (12) abhängig ist.

5. Thermoelektrische Vorrichtung nach den Ansprüchen 3 und 4, **dadurch gekennzeichnet,** dass sie eine Tabelle mit unterschiedlichen Schaltplänen der Schaltung in Abhängigkeit von einem erforderlichen Leistungswert und einem Potentialdifferenzwert umfasst.

6. Vorrichtung nach einem der vorhergehenden Ansprüche, **dadurch gekennzeichnet,** dass die Mittel zur Erfassung (6) der funktionellen thermoelektrischen Einzelsysteme ein Element zur Messung (7) des Stromdurchgangs in einem thermoelektrischen Einzelsystem der ersten Anordnung (5) von thermoelektrischen Einzelsystemen umfassen.

7. Vorrichtung nach einem der vorhergehenden Ansprüche, **dadurch gekennzeichnet,** dass jedes thermoelektrische Einzelsystem der ersten Anordnung (5) einen elektrischen Schalter, der zu seinen Anschlüssen parallel geschaltet ist, umfasst, wobei der Schalter einen Reihenwiderstand, der geringer als der des zugeordneten thermoelektrischen Einzelsystems ist, umfasst.

8. Vorrichtung nach einem der vorhergehenden Ansprüche, **dadurch gekennzeichnet,** dass die zweite Anordnung (9) von thermoelektrischen Einzelsystemen derart angeschlossen ist, dass die Schaltung eine Vielzahl von Reihen von thermoelektrischen Einzelsystemen umfasst, wobei alle Reihen eine identische Anzahl von thermoelektrischen Einzelsystemen umfassen und untereinander parallel geschaltet sind.

9. Verfahren zum Betrieb einer thermoelektrischen Vorrichtung, die eine erste Anordnung von thermoelektrischen Einzelsystemen umfasst, wobei die erste Anordnung wenigstens ein ausfallendes thermoelektrisches Einzelsysteme sowie funktionelle thermoelektrische Einzelsysteme umfasst und wobei das Verfahren die folgenden Schritte umfasst:

- Erfassen der funktionellen thermoelektrischen Einzelsysteme in der ersten Anordnung (5) von thermoelektrischen Einzelsystemen,
- Elektrisches Verbinden einer zweiten Anordnung (9) von funktionellen thermoelektrischen Einzelsystemen, welche aus der ersten Anordnung (5) von thermoelektrischen Einzelsystemen ausgewählt sind, um eine elektrische Schaltung zu bilden, so dass alle thermoelektrischen Einzelsysteme der elektrischen Schaltung von einem gleichen Strom durchflossen werden

10. Verfahren nach Anspruch 9, **dadurch gekennzeichet,** dass vor dem Schritt des elektrischen Verbindens ein Schaltplan der Schaltung in Abhängigkeit von einer Messung einer Potentialdifferenz an den Anschlüssen von wenigstens einem thermoelektrischen Einzelsysteme der zweiten Anordnung (9) oder an den Anschlüssen eines funktionellen thermoelektrischen Systems der ersten Anordnung (5) bestimmt wird.

11. Verfahren nach einem der Ansprüche 9 und 10, **dadurch gekennzeichnet,** dass, wenn die Schaltung dazu bestimmt ist, mit einem eine erforderliche Eingangsleistung aufweisenden Energieumwandlungselement (12) verbunden zu werden, die Anzahl der thermoelektrischen Einzelsysteme der zweiten Anordnung (9) von der erforderlichen Leistung abhängig ist.

**Claims**

1. A thermoelectric device comprising a first set (5) of identical unitary thermoelectric systems, each unitary thermoelectric system comprising at least one thermocouple, wherein the first set comprises functional unitary thermoelectric systems and at least one faulty unitary thermoelectric system, and in that the device comprises:

- means for detecting (6) functional unitary thermoelectric systems of the first set (5) of unitary thermoelectric systems,
- means (8) designed to electrically connect a second set (9) of functional unitary thermoelectric systems chosen from said first set (5) of unitary thermoelectric systems, in the form of an electric circuit, so that all the unitary thermoelectric systems of the electric circuit have the same current flowing through them.

2. The device according to claim 1, **characterized in that** it is designed to provide a predefined required power reached by the circuit, all the unitary thermoelectric systems of the circuit only being functional elements.

3. The device according to claim 1, **characterized in that** the electric diagram of the circuit depends on measurement of a potential difference performed by measuring means (11) connected to terminals of at least one unitary thermoelectric system of the second set (9), or to terminals of a functional unitary thermoelectric system of the first set (5).

4. The thermoelectric device according to one of claims 1 to 3, **characterized in that** it comprises an energy conversion element (12) electrically connected to the circuit, the number of unitary thermoelectric systems of the second set (9) depending on a required input power of the energy conversion element (12).

5. The thermoelectric device according to claims 3 and 4, **characterized in that** it comprises a table comprising different electric diagrams of the circuit according to a required power value and a potential difference value.

6. The device according to any one of the foregoing claims, **characterized in that** the means for detecting (6) the functional unitary thermoelectric systems comprise a measuring element (7) of the electric continuity in a unitary thermoelectric system of the first set (5) of unitary thermoelectric systems.

7. The device according to any one of the foregoing claims, **characterized in that** each unitary thermoelectric system of the first set (5) comprises an electric changeover switch connected in parallel to its terminals, said changeover switch comprising a series resistance lower than that of the associated unitary thermoelectric system.

8. The device according to any one of the foregoing claims, **characterized in that** the second set (9) of unitary thermoelectric systems is connected so that the circuit comprises a plurality of series of unitary thermoelectric systems, all the series comprising an identical number of unitary thermoelectric systems and being connected in parallel to one another.

9. An operating method of a thermoelectric device comprising a first set of unitary thermoelectric systems, wherein the first set comprises at least one faulty unitary thermoelectric system and functional unitary thermoelectric systems, and in that the method comprises the following steps:

- detecting the functional unitary thermoelectric systems in the first set (5) of unitary thermoelectric systems,
- electrically connecting a second set (9) of functional unitary thermoelectric systems, chosen from the first set (5) of unitary thermoelectric systems, to form an electric circuit so that all the unitary thermoelectric systems of said electric circuit have an identical current flowing through them.

10. The method according to claim 9, **characterized in that** prior to the electric connection step, an electric diagram of the circuit is determined according to measurement of a potential difference at the terminals of at least one unitary thermoelectric system of the second set (9) or at the terminals of a functional thermoelectric system of the first set (5).

11. The method according to one of claims 9 and 10, **characterized in that** the circuit being designed to be connected to an energy conversion element (12) comprising a required input power, the number of unitary thermoelectric systems of the second set (9) depends on said required power.

**Figure 1**

**Figure 2**

**Figure 3**

Figure 4

Figure 5

STU

12

Figure 6

12

STU

Figure 7

**RÉFÉRENCES CITÉES DANS LA DESCRIPTION**

**Documents brevets cités dans la description**

- US 5705770 A